# EUROPÄISCHE PATENTSCHRIFT

(11) **EP 2 230 696 B1**
(45) Veröffentlichungstag und Bekanntmachung des Hinweises auf die Patenterteilung: **23.11.2011**
(21) Anmeldenummer: 09004083.3
(22) Anmeldetag: 21.03.2009
(51) Int. Cl.: H01L 31/042, H01L 31/18

(54) **Photovoltaik-Modul**
Photovoltaic module
Module photovoltaïque

(43) Veröffentlichungstag der Anmeldung: 22.09.2010
(73) Patentinhaber: KIOTO Photovoltaics GmbH, 9300 St. Veit (AT)
(72) Erfinder: Napetsching, Georg, A-9103 (AT); Frank, Rudolf, 9064 Pischeldorf (AT); Eusch, Ingram, 9500 Vilach (AT)
(74) Vertreter: Becker, Thomas

(56) Entgegenhaltungen:
- EP-A- 0 540 797
- EP-A- 1 978 564
- DE-A1- 3 423 172
- DE-A1-102006 007 447

## Beschreibung

Die Erfindung betrifft einen Photovoltaik-Modul. Ein solcher Photovoltaik-Modul wird auch als "String" bezeichnet und besteht aus mehreren, mit Abstand und fluchtend zueinander angeordneten plattenförmigen Zellen, den so genannten Solarzellen. Jede Solarzelle weist auf einer ersten Haupt-Oberfläche eine Leiterbahn-Struktur auf, die eine erste Elektrode bildet, und eine zweite Haupt-Oberfläche ist jeweils als zweite Elektrode mit entgegen gesetzter Polarität ausgebildet. Alle Zellen sind bezüglich ihrer Haupt-Oberflächen identisch orientiert, das heißt, es ergibt sich innerhalb des Photovoltaik-Moduls aus mehreren Zellen eine fluchtende Ausrichtung der jeweiligen Zellen-Haupt-Oberflächen. Benachbarte Zellen sind jeweils über mindestens ein Flachband elektrisch verbunden, wobei das Flachband mit einem ersten Abschnitt mit der ersten Elektrode einer Zelle und mit einem zweiten Abschnitt mit der zweiten Elektrode einer benachbarten Zelle verlötet ist. Ein solcher String ergibt sich aus der EP 1978564 A.

Einen Photovoltaik-Modul der genannten Art zeigt die DE 10 2006 058 892 A1. Dabei wird beschrieben, dass die Solarzellen mit den auf ihrer Oberseite und Unterseite angeordneten Leiterbahnen auf einem Förderband nacheinander unter einen Lötstempel taktweise gebracht werden, um die entsprechende Lötverbindung zwischen Flachband und Elektrode herzustellen.

Bei dem Vorschlag gemäß DE 10 2006 058 892 A1 ist weiters vorgesehen, dass zwischen den Lötstempeln einerseits und den zu verbindenden Zellen andererseits eine dünne Schutzschicht angeordnet wird. Damit soll erreicht werden, dass die für den Lötvorgang notwendige Wärme nur gezielt an die Stellen gebracht wird, die verlötet werden sollen. Mit anderen Worten: das Lötband (Flachband) wird nur in den Bereichen erwärmt, in denen es auf der jeweiligen Zelle verlötet wird. Daraus ergeben sich im Randbereich einer Zelle Unregelmäßigkeiten insoweit, als dass das Lötband (Flachband) in den Abstandsbereichen zwischen benachbarten Zellen eine unterschiedliche Geometrie aufweist, weil es in diesem Bereich nicht wärmebehandelt wird. Diese Unstetigkeitsstellen bilden auch eine mechanische Schwachstelle in der Verbindung benachbarter Zellen.

Aufgrund der unterschiedlichen thermischen Belastung beim Lötvorgang (über 200° C) neigen die Zellen, die üblicherweise eine Dicke von unter 200 µm aufweisen, dazu, sich zu verformen. Durch den Transport der Zellen auf dem Förderband, das taktweise bewegt wird, besteht darüber hinaus die Gefahr eines Zellenbruchs.

Der Erfindung liegt die Aufgabe zugrunde, einen Photovoltaik-Modul der genannten Art anzubieten, der die beschriebenen Nachteile nicht aufweist. Darüber hinaus soll der Photovoltaik-Modul in einem vereinfachten Verfahren herstellbar sein.

Der Grundgedanke der Erfindung besteht darin, die Verlötung nicht paarweise und entsprechend nicht taktweise durchzuführen, sondern einen Photovoltaik-Modul aus mehrere(n) Zellen in einem gemeinsamen Arbeitsgang herzustellen, also mehrere Zellen in einem einzigen Arbeitsgang mit entsprechenden Lötbändern untereinander zu verbinden.

Daraus folgt, dass die Flachbänder zum Verbinden benachbarter Zellen über ihre gesamte Länge thermisch beaufschlagt werden und damit auch in den Bereichen zwischen den benachbarten Zellen. Damit ergibt sich eine homogenere Struktur der elektrischen Verbindung benachbarter Zellen und ein optimierter Stromfluss.

In ihrer allgemeinsten Ausführungsform betrifft die Erfindung einen Photovoltaik-Modul mit den Merkmalen von Anspruch 1.

Betrachtet man den Grundkörper des Flachbandes idealisiert als Blechstreifen mit zwei zueinander parallelen Haupt-Oberflächen, so folgt daraus, dass die lötbare Beschichtung im Wesentlichen auf den Haupt-Oberflächen des Flachbandes angeordnet ist. Dabei weist die Beschichtung im Rohzustand des Flachbandes auf beiden Seiten eine mehr oder weniger identische Materialstärke auf. Der Grundkörper kann beispielsweise überwiegend aus Kupfer bestehen und eine Breite von 1-3 mm, insbesondere 1,5-2,5 mm und eine Dicke von 0,1-0,3 mm, insbesondere 0,1-0,2 mm aufweisen, während die Beschichtung auf Zn-Basis auf beiden Haupt-Oberflächen beispielsweise jeweils 10-30 µm, insbesondere 10-20 µm dick ist.

Der erfindungsgemäße Photovoltaik-Modul unterscheidet sich vom Stand der Technik dadurch, dass die Beschichtung im Abschnitt zwischen benachbarten Zellen eine wechselnde Materialstärke aufweist. Die Veränderung gegenüber dem unbehandelten Flachband ergibt sich daraus, dass auch dieser Abschnitt des Flachbandes beim Herstellungsprozess durch den Lötstempel/die Lötlampe thermisch beaufschlagt wurde und das Beschichtungsmaterial beim Lötvorgang vom festen in den viskosen/flüssigen Zustand überführt wurde, so dass es in den genannten Bereich zumindest partiell sich verformt hat. Dies insbesondere deshalb, weil das Flachband im Übergangsbereich zwischen benachbarten Zellen nicht geradlinig verläuft, wie auf den Haupt-Oberflächen der Zellen, sondern S-förmig, weil es von einer Haupt-Oberfläche einer Zelle auf die gegenüberliegende Haupt-Oberfläche der benachbarten Zelle gekrümmt verläuft. Trotz der relativ geringen Materialstärke der Zellen kommt es durch die Erwärmung und Gravitationseinflüsse zu einem "Abfließen" des Beschichtungsmaterials entlang der genannten Krümmungsabschnitte und damit zur Ausbildung unterschiedlicher Beschichtungsstärken an unterschiedlichen Stellen/Abschnitten des Flachbandes zwischen benachbarten Zellen. Auf diese Weise wird eine Verteilung des Beschichtungsmaterials ohne Stufen und ohne spontane Querschnittsänderung erreicht.

Das nachfolgende Ausführungsbeispiel zeigt schematisch den beschriebenen Effekt.

Die Abweichungen der Materialstärke im genannten Bereich können über 40 %, über 60 %, aber auch über 80 % betragen. So kann beispielsweise am fertigen String die Beschichtung an einer Stelle eine Materialstärke von 8 µm und an einer anderen Stelle eine Materialstärke von 25 µm aufweisen. Häufig sind die Unterschiede deutlicher, beispielsweise 2 µm an einer Stelle und 35 µm an einer anderen Stelle.

Die Leiterbahnstruktur einer Solarzelle kann beispielsweise zwei parallel und im Abstand zueinander verlaufende Busbars aufweisen, wobei jeder Busbar mit einem Flachband verlötet ist. Dem Busbar zugeordnet sind weitere elektrische Leiterbahnen, die in der Regel senkrecht zu den Busbars im Abstand zueinander verlaufen.

Das Verfahren zur Herstellung des beschriebenen Photovoltaik-Moduls umfasst die Schritte des Anspruchs 5.

Zu diesen weiteren Prozessschritten gehört die Konfektionierung mehrerer Photovoltaik-Module zu größeren Einheiten, die dann beispielsweise auf einem Dach zur Stromgewinnung montiert werden können.

Die Positionierung der Zellen auf dem Träger wird erleichtert, wenn die Zellen in korrespondierenden Vertiefungen des Trägers aufgelegt werden. Die Vertiefungen sichern eine exakte Ausrichtung der Zellen zueinander. Es können auch die Zellen mehrerer Strings gleichzeitig verlötet werden, und zwar nicht nur innerhalb eines Strings, sondern auch benachbarte Strings untereinander.

Die thermische Beaufschlagung, also das Verlöten der Zellen, kann mittels Halogenlicht erfolgen. Üblicherweise werden dabei Temperaturen zwischen 150 und 250° C benötigt, um die Lötverbindungen herstellen zu können.

Grundsätzlich reicht es, die Wärmequelle(n) auf einer Seite des Strings anzuordnen, da die thermische Energie ausreicht, um auch die auf der gegenüber liegenden Haupt-Oberfläche verlaufenden Flachbänder aufzulöten. Nach einer Ausführungsform sind jedoch mehrere Wärmequellen vorgesehen, die mit Abstand zu beiden Haupt-Oberflächen der Zellen vor diesen angeordnet sind. Hierdurch wird eine Vergleichmäßigung der Wärmeenergie auf beiden Seiten des Strings erreicht.

Weitere Merkmale der Erfindung ergeben sich aus den Merkmalen der Unteransprüche sowie den sonstigen Anmeldungsunterlagen.

Die Erfindung wird nachstehend anhand eines Ausführungsbeispieles näher erläutert. Dabei zeigen, jeweils in schematisierter Darstellung:
Figur 1: eine Aufsicht auf einen Photovoltaik-Modul aus fünf Solarzellen
Figur 2: eine Seitenansicht zweier benachbarter Solarzellen.

In den Figuren sind gleiche oder gleich wirkende Bauteile mit gleichen Bezugsziffern dargestellt.

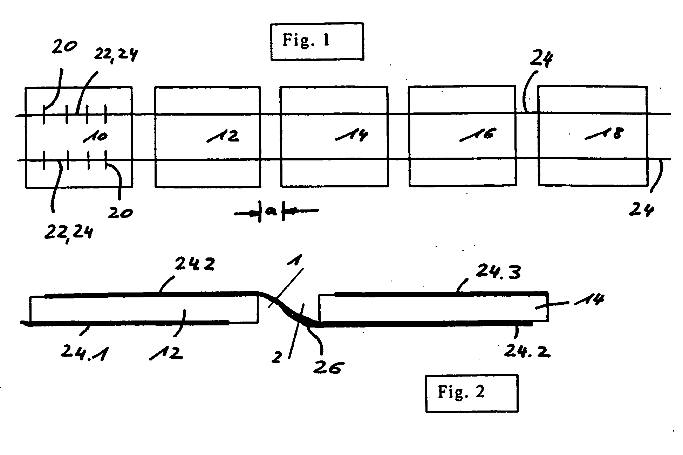

Der Photovoltaik-Modul gemäß Figur 1 besteht aus fünf Solarzellen 10, 12, 14, 16, 18. Die Ansicht zeigt die n-dotierten Haupt-Oberflächen der Zellen 10, 12, 14, 16, 18, die mit Abstand - a - zueinander angeordnet sind und jeweils auf ihrer Oberseite eine Leiterbahnstruktur aufweisen, die aus einer Vielzahl von im Abstand zueinander angeordneten Kontakten 20 besteht, die wechselweise zwei so genannten Busbars 22 zugeordnet und mit diesen elektrisch verbunden sind (nur für Zelle 10 dargestellt). Die Busbars 22 liegen unter den nachstehend beschriebenen Flachbändern 24.

Auf die dargestellte Oberseite der Zelle 10 sind zwei Flachbänder 24 auf den beiden Busbars 22 aufgelötet, wobei sich die Flachbänder 24 über die Zelle 10 rechts hinaus erstrecken und unter die benachbarte Zelle 12 verlaufen, wo sie mit der auf der Unterseite der Zelle 12 angeordneten Elektrode verlötet sind. Analog gilt dies für die Verbindung von jeweils zwei benachbarten Zellen, wobei die Flachbänder 24 die in Figur 1 rechts dargestellte Zelle 18 endseitig überragen und elektrische Anschlüsse bilden. Dies gilt analog für die Zelle 10.

Figur 2 zeigt in der Seitenansicht eine vergrößerte Darstellung der Zellen 12, 14, einschließlich der darauf angeordneten Flachbänder 24.

Auf der Unterseite der Zelle 12 ist ein erstes Flachband 24.1 aufgelötet, welches von der Zelle 10 kommt. Auf der Oberseite der Zelle 12 verläuft ein weiteres Flachband 24.2, welches mit einem korrespondierenden Busbar verlötet ist. Das Flachband 24.2 erstreckt sich in Richtung auf die benachbarte Zelle 14 in einem S-förmigen Verlauf unter die Unterseite der Zelle 14, wo es analog zum Flachband 24.1 verlötet ist. Auf der Oberseite der Zelle 14 ist ein Flachband 24.3 zu erkennen, das zur Zelle 16 verläuft.

Zur Veranschaulichung ist in übertriebener Darstellung im Übergangsbereich zwischen den Zellen 12 und 14 die Materialstärke einer Beschichtung 26 auf einem Grundkörper des Flachbandes 24.2 dargestellt. Es ist zu erkennen, dass die Beschichtung 26 nicht in gleichmäßiger Materialstärke auf den Haupt-Oberflächen des Grundkörpers verläuft, sondern dickere und dünnere Abschnitte aufweist. Dies ist eine Folge der Herstellung des dargestellten Strings, der als Einheit aus fünf Zellen 10, 12, 14, 16, 18 in einem gemeinsamen Lötvorgang hergestellt wurde. Die Wärmequelle ist dabei über und/oder unter dem gesamten String angeordnet und wirkt auf den String über dessen Gesamtfläche. Durch die Wärmeeinwirkung im Übergangsbereich zwischen benachbarten Zellen (hier: 12, 14) ist das Beschichtungsmaterial verlaufen und hat die dargestellte Geometrie angenommen. An der symbolisch eingezeichneten Schnittstelle 1 beträgt die Dicke der Beschichtung 26 auf der Oberseite des Grundkörpers beispielsweise 8 µm und auf der Unterseite 15 µm, während die Beschichtungsdicke im Schnittbereich 2 oberseitig 4 µm und unterseitig 30 µm beträgt.

Von besonderer Bedeutung ist, dass sich im Übergangsbereich von der Auflagefläche des Flachbandes 24.2 auf der Zelle 12 zum Freibereich keine stufige Veränderung der Beschichtungsstärke ausgebildet hat, sondern ein weicher, homogener Übergang, der wesentlich dafür ist, dass das Flachband 24.2 weniger bruchgefährdet ist als beim Stand der Technik.

Darüber hinaus hat das beschriebene Herstellungsverfahren den Vorteil, dass durch ein homogenes Wärmebild über den gesamten String sich eine extreme Bruchreduzierung auch für die Zellen ergibt und der Lötvorgang insgesamt erheblich beschleunigt wird, da nunmehr alle Zellen gleichzeitig verlötet werden.

## Patentansprüche

1. Photovoltaik-Modul mit folgenden Merkmalen:
- mehreren, mit Abstand und fluchtend zueinander angeordneten plattenförmigen Zellen (10, 12, 14, 16, 18)
- jede Zelle (10, 12, 14, 16, 18) weist auf einer ersten Haupt-Oberfläche eine Leiterbahn-Struktur (22,24) auf, die eine erste Elektrode bildet und eine zweite Haupt-Oberfläche ist jeweils als zweite Elektrode mit entgegen gesetzter Polarität ausgebildet,
- alle Zellen (10, 12, 14, 16, 18) sind bezüglich ihrer Haupt-Oberflächen identisch orientiert,
- benachbarte Zellen (10,12; 12,14; 14,16; 16,18; 18,20) sind jeweils über mindestens ein Flachband (24) elektrisch verbunden,
- das Flachband (24) weist auf einem Grundkörper eine lötbare Beschichtung (26) auf,
- das Flachband (24) ist mit einem ersten Abschnitt mit der ersten Elektrode einer Zelle (10, 12, 14, 16, 18) und mit einem zweiten Abschnitt mit der zweiten Elektrode einer benachbarten Zelle (12, 14, 16, 18) verlötet, wobei
- die Beschichtung (26) im Abschnitt zwischen benachbarten Zellen (10,12; 12,14; 14,16; 16,18; 18,20)) an mindestens zwei Stellen (1,2) eine um mindestens 30% voneinander abweichende Materialstärke, relativ zum Grundkörper des Flachbandes (24), aufweist.

2. Photovoltaik-Modul nach Anspruch 1, bei dem die Beschichtung (26) im Abschnitt zwischen benachbarten Zellen (10,12; 12,14; 14,16; 16,18; 18,20)) an mindestens zwei Stellen (1,2) eine um mindestens 40% voneinander abweichende Materialstärke aufweist.

3. Photovoltaik-Modul nach Anspruch 1, bei dem die Beschichtung (26) im Abschnitt zwischen benachbarten Zellen (10,12; 12,14; 14,16; 16,18; 18,20)) an mindestens zwei Stellen (1,2) eine um mindestens 60% voneinander abweichende Materialstärke aufweist.

4. Photovoltaik-Modul nach Anspruch 1, bei dem die Beschichtung (26) im Abschnitt zwischen benachbarten Zellen (10,12; 12,14; 14,16; 16,18; 18,20)) an mindestens zwei Stellen (1,2) eine um mindestens 80% voneinander abweichende Materialstärke aufweist.

5. Verfahren zur Herstellung eines Photovoltaik-Moduls nach Anspruch 1, mit folgenden Merkmalen:
5.1 eine erste Zelle wird auf einen Träger aufgelegt,
5.2 mindestens ein Flachband mit einem Grundkörper und einer darauf angeordneten lötbaren Beschichtung wird mit einem Abschnitt auf die frei liegende erste Elektrode der ersten Zelle aufgelegt,
5.3 auf den zweiten Abschnitt des Flachbandes wird eine zweite Zelle so aufgelegt, dass sie im Abstand zur ersten Zelle liegt und die zweite Elektrode der zweiten Zelle den zweiten Abschnitt des Flachbands kontaktiert,
5.4 die Schritte 5.2 und 5.3 werden anschließend wiederholt, bis der Modul n Zellen umfasst,
5.5 der Modul mit n Zellen wird in einem anschließenden Verfahrensschritt von mindestens einer Seite thermisch so beaufschlagt, dass eine Lötverbindung zwischen den Flachbändern und korrespondierenden Elektroden der Zellen entsteht und die Beschichtung im Abschnitt zwischen benachbarten Zellen an mindestens zwei Stellen eine um mindestens 30% voneinander abweichende Materialstärke, relativ zum Grundkörper des Flachbandes, aufweist,
5.6 danach wird der Träger mit dem darauf liegenden Modul weiteren Prozessschritten zugeführt.

6. Verfahren nach Anspruch 5, bei dem die Zellen in korrespondierenden Vertiefungen des Trägers aufgelegt werden.

7. Verfahren nach Anspruch 5, bei dem die Zellen mittels Halogenlicht thermisch beaufschlagt werden.

8. Verfahren nach Anspruch 5 mit mehreren Wärmequellen, die mit Abstand zu beiden Hauptoberflächen der Zellen vor diesen angeordnet sind.

## Claims

1. Photovoltaic module with the following features:
- a plurality of plate-shaped cells (10, 12, 14, 16, 18) which are arranged at a distance from each other and flush with each other
- each cell (10, 12, 14, 16, 18) has a conductor track structure (22, 24) which forms a first electrode on a first main surface, and a second main surface is configured in each case as a second electrode with opposed polarity,
- all cells (10, 12, 14, 16, 18) are oriented identically with respect to their main surfaces,
- adjacent cells (10,12; 12,14; 14,16; 16,18; 18,20) are electrically connected in each case by means of at least one flat band (24),
- the flat band (24) has a solderable coating (26) on a base body,
- the flat band (24) is soldered with a first section to the first electrode of one cell (10, 12, 14, 16, 18) and with a second section to the second electrode of an adjacent cell (12, 14, 16, 18), wherein
- the coating (26) in the section between adjacent cells (10,12; 12,14; 14,16; 16,18; 18,20) at at least two points (1, 2) has material thicknesses which deviate from each other by at least 30%, relative to the base body of the flat band (24).

2. Photovoltaic module according to Claim 1, in which the coating (26) in the section between adjacent cells (10,12; 12,14; 14,16; 16,18; 18,20) at at least two points (1, 2) has material thicknesses which deviate from each other by at least 40%.

3. Photovoltaic module according to Claim 1, in which the coating (26) in the section between adjacent cells (10,12; 12,14; 14,16; 16,18; 18,20) at at least two points (1, 2) has material thicknesses which deviate from each other by at least 60%.

4. Photovoltaic module according to Claim 1, in which the coating (26) in the section between adjacent cells (10,12; 12,14; 14,16; 16,18; 18,20) at at least two points (1, 2) has material thicknesses which deviate from each other by at least 80%.

5. Method for producing a photovoltaic module according to Claim 1, with the following features:
5.1 a first cell is placed on a support,
5.2 at least one flat band with a base body and a solderable coating thereupon is placed with one section on the exposed first electrode of the first cell,
5.3 a second cell is placed on the second section of the flat band in such a manner that it lies at a distance from the first cell and the second electrode of the second cell contacts the second section of the flat band,
5.4 the steps 5.2 and 5.3 are then repeated until the module comprises n cells,
5.5 the module with n cells is thermally loaded from at least one side in a subsequent method step in such a manner that a soldered connection is produced between the flat bands and corresponding electrodes of the cells and in such a manner that the coating in that section between adjacent cells at at least two points has material thicknesses which deviate from each other by at least 30%, relative to the base body of the flat band,
5.6 the support with the module lying on it is then fed to further process steps.

6. Method according to Claim 5, in which the cells are placed into corresponding depressions in the support.

7. Method according to Claim 5, in which the cells are thermally treated using halogen light.

8. Method according to Claim 5, having a plurality of heat sources, which are arranged in front of the cells at a distance from both main surfaces of the cells.

## Revendications

1. Module photovoltaïque présentant les caractéristiques suivantes :
- plusieurs cellules (10, 12, 14, 16, 18) en forme de plaque, disposées à distance et en alignement les unes par rapport aux autres,
- chaque cellule (10, 12, 14, 16, 18) présente sur une première surface principale une structure de piste conductrice (22, 24), qui forme une première électrode et une seconde surface principale est conçue à chaque fois comme seconde électrode avec une polarité opposée,
- toutes les cellules (10, 12, 14, 16, 18) sont orientées de façon identique par rapport à leurs surfaces principales,
- des cellules voisines (10, 12 ; 12, 14 ; 14, 16 ; 16, 18 ; 18, 20) sont reliées respectivement à chaque fois au moyen d'au moins une bande plate (24),
- la bande plate (24) présente sur un corps de base un revêtement (26) brasable,
- la bande plate (24) est soudée par un premier tronçon avec la première électrode d'une cellule (10, 12, 14, 16, 18) et par un second tronçon avec la seconde électrode d'une cellule voisine (12, 14, 16, 18),
- le revêtement (26) présentant dans le tronçon entre des cellules voisines (10, 12 ; 12, 14 ; 14, 16 ; 16, 18 ; 18, 20) en au moins deux endroits (1, 2) une épaisseur de matériau différente d'au moins 30 %, par rapport au corps de base de la bande plate (24).

2. Module photovoltaïque selon la revendication 1, sur lequel le revêtement (26) présente dans le tronçon entre des cellules voisines (10, 12 ; 12, 14 ; 14, 16 ; 16, 18 ; 18, 20) en au moins deux endroits (1, 2) une épaisseur de matériau différente d'au moins 40 %.

3. Module photovoltaïque selon la revendication 1, sur lequel le revêtement (26) présente dans le tronçon entre des cellules voisines (10, 12 ; 12, 14 ; 14, 16 ; 16, 18 ; 18, 20) en au moins deux endroits (1, 2) une épaisseur de matériau différente d'au moins 60 %.

4. Module photovoltaïque selon la revendication 1, sur lequel le revêtement (26) présente dans le tronçon entre des cellules voisines (10, 12 ; 12, 14 ; 14, 16 ; 16, 18 ; 18, 20) en au moins deux endroits (1, 2) une épaisseur de matériau différente d'au moins 80 %.

5. Procédé pour fabriquer un module photovoltaïque selon la revendication 1, présentant les caractéristiques suivantes :
5.1 une première cellule est posée sur un support,
5.2 au moins une bande plate avec un corps de base et un revêtement disposé dessus et brasable est posée avec un tronçon sur la première électrode dégagée de la première cellule,
5.3 sur le second tronçon de la bande plate, une seconde cellule est posée de telle sorte qu'elle se situe à distance de la première cellule et met la seconde électrode de la seconde cellule en contact avec le second tronçon de la bande plate,
5.4 les étapes 5.2 et 5.3 sont répétées ensuite jusqu'à ce que le module comprenne n cellules,
5.5 le module présentant n cellules est sollicité thermiquement dans une étape de procédé consécutive par au moins un côté, de telle sorte qu'une liaison brasée se forme entre les bandes plates et les électrodes correspondantes des cellules et que le revêtement présente dans le tronçon entre des cellules voisines en au moins deux emplacements une épaisseur de matériau différente d'au moins 30 %, par rapport au corps de base de la bande plate,
5.6 ensuite, le support est amené avec le module reposant dessus à d'autres étapes de processus.

6. Procédé selon la revendication 5, dans lequel les cellules sont posées dans des cavités correspondantes du support.

7. Procédé selon la revendication 5, dans lequel les cellules sont sollicitées thermiquement au moyen de lumière halogène.

8. Procédé selon la revendication 5 comprenant plusieurs sources de chaleur, qui sont disposées à distance des deux surfaces principales des cellules en amont de celles-ci.
